# FASCICULE DE BREVET EUROPEEN

(11) **EP 0 615 272 B1**
(45) Date de publication et mention de la délivrance du brevet: **04.12.1996**
(21) Numéro de dépôt: 94400477.9
(22) Date de dépôt: 07.03.1994
(51) Int. Cl.: H01J 37/073, H01J 3/02

(54) **Structure de guidage de particules chargées en électricité**
Anordnung zum Führen von elektrisch geladenen Teilchen
Guiding structure for electrically charged particles

(30) Priorité: 09.03.1993 FR 9302699
(43) Date de publication de la demande: 14.09.1994
(73) Titulaire: COMMISSARIAT A L'ENERGIE ATOMIQUE, 75015 Paris (FR); CENTRE NATIONAL DE LA RECHERCHE SCIENTIFIQUE (CNRS), 75700 Paris Cedex 07 (FR); Duval, Jean, F-78330 Fontenay le Fleury (FR)
(72) Inventeur: Delferriere, Olivier, F-91400 Orsay (FR); Faure, Jean, F-78320 Levis St. Nom (FR); Gobin, Raphael, F-91410 Dourdan (FR); Duval, Jean, F-78330 Fontenay le Fleury (FR)
(74) Mandataire: Ilgart, Jean-Christophe

(56) Documents cités:
- EP-A- 0 509 771
- US-A- 4 803 398

## Description

L'invention se rapporte à une structure de guidage de particules chargées en électricité.

De telles structures sont composées d'électrodes en forme de bagues traversées par la trajectoire que les particules empruntent, d'un manchon isolant autour des électrodes et de supports reliant le manchon aux électrodes. Les supports sont traditionnellement constitués de disques brasés aux électrodes et pincés entre deux segments successifs du manchon, auxquels ils sont également brasés. Cette disposition présente un inconvénient parce que d'importantes contraintes internes sont produites dans le manchon, qui est normalement en céramique et donc fragile, pendant le brasage, et des contraintes résiduelles subsistent ensuite du fait des caractéristiques thermomécaniques des matériaux utilisés. On a tenté, afin de réduire ces contraintes et les risques de rupture du manchon qui en découlent, de pourvoir les disques d'ondulations ou de fentes qui les rendent plus souples, mais des défauts d'alignement et de centrage des électrodes fort nuisibles pour le bon guidage des particules apparaissent. Et les métaux et alliages usuels dont le coefficient de dilatation thermique est proche de celui de la céramique ne conviennent pas pour cette application à cause de la fragilité de leurs brasures, de leur magnétisme ou de leur mauvaise tenue au vide dans lequel ces dispositifs sont normalement employés ; en plus, leur déformation entraîne la perte de la précision nécessaire pour ce type de montage.

L'invention est caractérisée en ce que les supports sont des rayons encastrés dans les électrodes et dans le manchon et contraints en traction ; le manchon peut avantageusement être construit d'un seul tenant. Un encastrement satisfaisant au sens de l'invention est assuré par une liaison rigide telle qu'une brasure.

Les inconvénients mentionnés plus haut au sujet des structures connues disparaissent alors : la contrainte en traction des rayons garantit leur absence de flexion et donc un bon alignement des électrodes, sans produire de contraintes internes importantes dans la céramique ; enfin, les rayons dégazent peu à cause de leur faible surface, et la qualité du vide ambiant est donc mieux préservée.

L'invention va maintenant être décrite plus en détail à l'aide des figures suivantes annexées à titre illustratif et non limitatif :
- la figure 1 est une vue d'une structure de l'art antérieur, et
- la figure 2 est une vue d'une réalisation de l'invention.

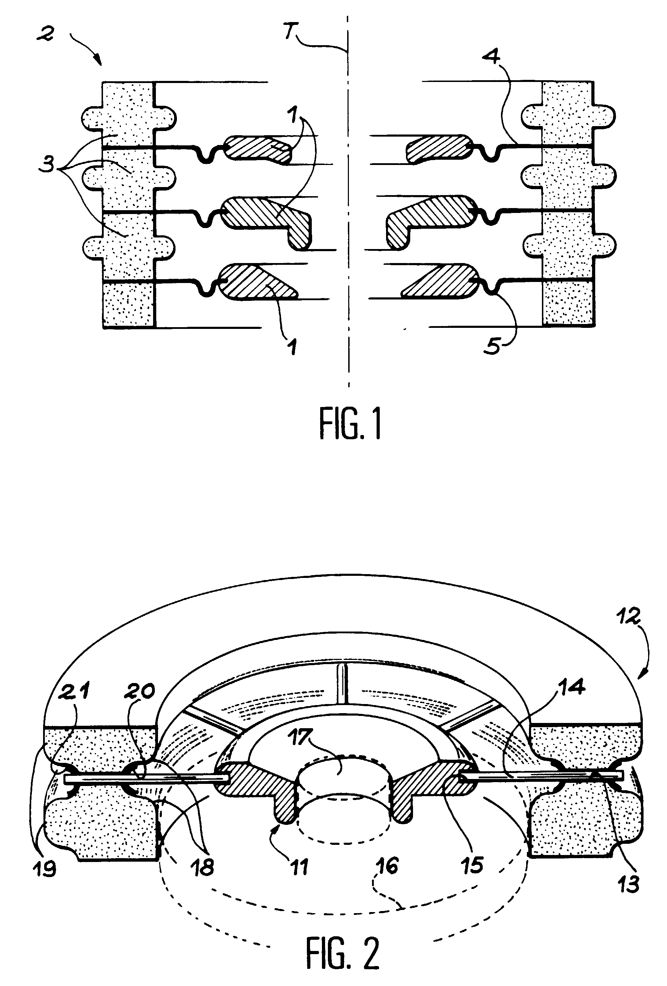

Les électrodes 1 de la figure 1 sont des bagues portées à des potentiels électriques choisis grâce à des moyens d'alimentation non représentés, et qui sont alignées sur un axe commun qui constitue la trajectoire T que les particules chargées doivent parcourir en étant accélérées, ralenties ou déviées par les électrodes 1.

Le manchon 2 est formé de segments annulaires 3 en céramique superposés . Des bords extérieurs de disques 4, dont les bords intérieurs sont encastrés et brasés dans des gorges périphériques des électrodes 1 respectives, sont bloqués entre des paires de segments annulaires 3 consécutifs. On a figuré des ondulations 5 sur le disque 4 afin les rendre plus souples et de réduire les contraintes d'origine thermique.

La structure conforme à l'invention comporte généralement plusieurs électrodes 11, bien qu'on n'en représente qu'une dans cette réalisation. Le manchon 12 est avantageusement d'une pièce et il possède au niveau de chaque électrode 11 des évidements radiaux 13 dans chacun desquels est brasée l'extrémité extérieure d'un rayon 14 dont l'extrémité intérieure est brasée dans un trou 15 du bord extérieur de l'électrode 11. Les matériaux sont choisis de sorte que les rayons 14 soient contraints en traction aux températures de service. On pourra par exemple prendre des électrodes 11 en tungstène, molybdène ou tantale, métaux réfractaires dont le coefficient de dilatation est inférieur à celui de l'alumine qui forme généralement le manchon 12. Mais comme les rayons 14 sont construits en alliages tels que l'acier inoxydable ou l'Inconel dont le coefficient de dilatation est encore plus élevé, le refroidissement du dispositif consécutif au brasage amène leur mise en traction élastique, ce qui garantit la précision requise.

Une fabrication aisée peut être obtenue si, avant de braser les rayons 14, l'électrode 11 est posée sur une roue de centrage 16 ajustée dans le manchon 12 avec un faible jeu et dont la hauteur est choisie pour que les trous 15 viennent au niveau des perçages 13. Le centrage de l'électrode 11 est réalisé par un tenon circulaire 17 au centre de la roue 16 et qui s'engage dans l'évidement central de l'électrode 11. Des roues semblables mais de différentes hauteurs permettent ainsi de placer les électrodes 11 successivement.

La paroi interne du manchon 12 est avantageusement formée de renflements 18 en forme d'ondulations entre les rayons 14 des électrodes 11 consécutives, afin de réduire les fuites électriques d'une électrode 11 à l'autre en accroissant leur distance mesurée à la surface du manchon 12. Les perçages 13 sont donc établis à travers les régions les plus minces du manchon 12, entre les renflements 18, ce qui permet de braser les rayons 14 sur toute leur longueur. Des renflements 19 sont établis également, et pour la même raison, sur la surface externe du manchon 12, devant les renflements 18. La mise sous tension des électrodes est obtenue par un contact établi à l'extrémité extérieure dépassante d'un rayon.

Les fonds des gorges apparaissant entre les renflements 18 et 19 peuvent être avantageusement métallisés de façon à assurer la continuité de la surface équipotentielle dans le plan des rayons 14, et éviter ainsi des disruptions.

Les cercles métallisés qui relient les rayons 14 d'une même électrode 11 entre eux sont figurés par les dépôts conducteurs de l'électricité 20 et 21.

## Revendications

1. Structure de guidage de particules chargées en électricité, composée d'électrodes (11) situées le long d'une trajectoire (T) des particules, d'un manchon (12) autour des électrodes (11) et de supports (14) reliant le manchon (12) aux électrodes (11), caractérisée en ce que les supports (14) sont des rayons encastrés dans les électrodes (11) et dans le manchon (12) et contraints en traction.

2. Structure de guidage suivant la revendication 1, caractérisée en ce que le manchon a des surfaces munies de renflements (18 et 19) entre des rayons d'électrodes (11) consécutives.

3. Structure de guidage suivant l'une quelconque des revendications 1 ou 2, caractérisée en ce que le manchon (12) est d'une pièce.

4. Structure de guidage suivant l'une quelconque des revendications 1 à 3, caractérisée en ce que des dépôts circulaires conducteurs de l'électricité (20 et 21) reliant les rayons d'une même électrode (11) entre eux sont établis sur le manchon (12).

## Patentansprüche

1. Anordnung zum Führen von elektrisch geladenen Teilchen, gebildet durch längs einer Teilchenbahn (T) angeordnete Elektroden (11), durch einen Mantel (12) um die Elektroden (11) herum und durch Halter (14), die den Mantel (12) mit den Elektroden (11) verbinden,
**dadurch gekennzeichnet,**
daß die Halter (14) Speichen sind, die in die Elektroden (11) und in den Matel (12) eingelassen bzw. eingefügt sind und auf Zug beansprucht werden.

2. Anordnung nach Anspruch 1,
dadurch gekennzeichnet, daß der Mantel Oberflächen aufweist, die zwischen Speichen von aufeinanderfolgenden Elektroden (11) mit Verdickungen bzw. Wülsten (18 und 19) versehen sind.

3. Anordnung nach einem der Ansprüche 1 oder 2,
dadurch gekennzeichnet, daß der Mantel (12) aus einem Stück ist.

4. Anordnung nach einem der Ansprüche 1 bis 3,
dadurch gekennzeichnet, daß kreisförmige, elektrisch leitfähige Abscheidungen bzw. Niederschläge (20 und 21), welche die Speichen von ein und derselben Elektrode (11) miteinander verbinden, auf dem Mantel (12) hergestellt sind.

## Claims

1. Structure for guiding electrically charged particles, composed of electrodes (11) located along a trajectory (T) of the particles, a sleeve (12) around the electrodes (11), and supports (14) joining the sleeve (12) to the electrodes (11), characterized in that the supports (14) are spokes which are embedded in the electrodes (11) and in the sleeve (12) and are under tensile stress.

2. Guide structure according to Claim 1, characterized in that the sleeve has surfaces provided with protuberances (18 and 19) between consecutive spokes of the electrodes (11).

3. Guide structure according to either of Claims 1 and 2, characterized in that the sleeve (12) is monobloc.

4. Guide structure according to any one of Claims 1 to 3, characterized in that circular electrically conductive deposits (20 and 21) joining together the spokes of a single electrode (11) are formed on the sleeve (12).
